# EUROPEAN PATENT APPLICATION

(11) **EP 2 830 396 A1**
(43) Date of publication of application: **28.01.2015**
(21) Application number: 13803767.6
(22) Date of filing: 27.02.2013
(51) Int. Cl.: H05B 33/10, H01L 51/50, H05B 33/02, H05B 33/26

(54) **ORGANIC EL DEVICE MANUFACTURING METHOD AND ORGANIC EL DEVICE**

(30) Priority: 11.06.2012 JP 2012132356
(71) Applicant: Nitto Denko Corporation, Ibaraki-shi, Osaka 567-8680 (JP)
(72) Inventor: NAKAI Takahiro, Ibaraki-shi Osaka 567-8680 (JP); MORITA Shigenori, Ibaraki-shi Osaka 567-8680 (JP); SUNAGAWA Hiroshi, Ibaraki-shi Osaka 567-8680 (JP)
(74) Representative: Hoffmann Eitle
(86) International application number: PCT/JP2013/055147
(87) International publication number: WO 2013/187089

(57) **Abstract**

The present invention provides a method for producing an organic EL device and the organic EL device, capable of enhancing reliability of the organic EL device by suppressing peeling caused by stress concentration to each layer end through reduction in the stress concentration even in the case of using a roll-to-roll process. The method includes: supplying a substrate (101) from a delivery roll to a wind-up roll; forming a first electrode layer (102) over the substrate (101); forming an organic EL layer (103) over the first electrode layer (102); and forming a second electrode layer (104) over the organic EL layer (103). The first electrode layer (102) is formed using a shadow mask. At least a part of a side surface of the first electrode layer (102) is a tapered surface (102T) of inwardly sloping from a lower side toward an upper side. An angle formed between the tapered surface (102T) and a surface of the substrate (101) on the side over which the first electrode layer (102) is formed is 1° or less.

## Description

### Technical Field

The present invention relates to a method for producing an organic EL device and an organic EL device.

### Background Art

Recently, a technique of forming an organic EL (electroluminescence) element on a narrow band-like base by a roll-to-roll process has been known (for example, see Patent Document 1). The roll-to-roll process is a continuous production process of continuously producing an organic EL device by using a flexible substrate as a base, winding up the substrate on a roll, performing processing such as forming an electrode and an organic EL layer over the substrate or the like while drawing and moving the substrate by rotating the roll, and again winding up the processed substrate on another roll.

### Prior Art Document

### Patent Document

Patent Document 1: JP 2008-287996 A

### Summary of Invention

### Problem to be Solved by the Invention

However, since a flexible substrate is used in the organic EL device formed by the roll-to-roll process, there are problems in that peeling caused by stress concentration to the end of each layer is prone to occur, and the reliability of the organic EL device is impaired (the organic EL element is then likely to be destroyed).

The present invention was made in view of the above problems and is intended to enhance reliability of an organic EL device by suppressing peeling caused by stress concentrated at the end of each layer through a reduction in the stress concentration even in the case of using a roll-to-roll process.

### Means for Solving Problem

The method for producing an organic EL device, according to the present invention, is a method for producing an organic EL device, including supplying a substrate from a delivery roll to a wind-up roll; forming a first electrode layer over the substrate; forming an organic EL layer over the first electrode layer; and forming a second electrode layer over the organic EL layer, wherein the first electrode layer is formed using a shadow mask, at least a part of a side surface of the first electrode layer is a tapered surface of inwardly sloping from a lower side toward an upper side, and an angle formed between the tapered surface and a surface of the substrate on the side over which the first electrode layer is formed is 1° or less.

The organic EL device according to the present invention is an organic EL device including: a flexible substrate; a first electrode layer; an organic EL layer; and a second electrode layer, the first electrode layer, the organic EL layer, and the second electrode layer being laminated over the flexible substrate in this order, wherein at least a part of a side surface of the first electrode layer is a tapered surface of inwardly sloping from a lower side toward an upper side, and an angle formed between the tapered surface and a surface of the substrate on the side over which the first electrode layer is formed is 1° or less.

### Effects of the Invention

According to the present invention, the reliability of an organic EL device can be enhanced by suppressing peeling caused by stress concentration to the end of each layer through a reduction in the stress concentration even in the case of using a roll-to-roll process. Moreover, as a secondary effect of the present invention, a reduction in yield, caused by a residue and the like generated by photolithography and the like can be suppressed.

### Brief Description of Drawings

[FIG. 1] FIG. 1 is a schematic cross-sectional view showing an example of a configuration of an organic EL device in the present invention.
[FIG. 2] FIG. 2 is a schematic cross-sectional view showing an example of a shape of the vicinity of an opening in a shadow mask used in the method for producing an organic EL device, according to the present invention.
[FIG. 3] FIG. 3 is a schematic cross-sectional view showing another example of a shape of the vicinity of an opening in a shadow mask used in the method for producing an organic EL device, according to the present invention.
[FIG. 4] FIG. 4 is a schematic cross-sectional view showing yet another example of a shape of the vicinity of an opening in a shadow mask used in the method for producing an organic EL device, according to the present invention.
[FIG. 5] FIG. 5 is an explanatory drawing of arrangements of a substrate and a shadow mask in the forming a first electrode layer.
[FIG. 6] FIG. 6 is a perspective view of the vicinity of an opening in a shadow mask in the forming a first electrode layer.
[FIG. 7] FIG. 7 is a schematic cross-sectional view showing an example of a configuration of an organic EL device of comparative examples. Description of Embodiments

In the method for producing an organic EL device, according to the present invention (hereinafter referred to as an "organic EL device production method according to the present invention"), a cross-sectional shape of an inside surface of an opening in the shadow mask preferably has a tapered shape or a multistage shape.

In the organic EL device production method according to the present invention, it is preferred that an inside end of an opening in the shadow mask has a constant thickness, and the thickness is in the range from 5 to 500 µm.

In the forming the organic EL layer of the organic EL device production method according to the present invention, the organic EL layer is preferably formed using a shadow mask for forming an organic EL layer.

In the forming an second electrode layer of the organic EL device production method according to the present invention, the second electrode layer is preferably formed using a shadow mask for forming a second electrode layer.

In the organic EL device production method according to the present invention, a recoverable long band-like substrate with a width in the range from 10 to 100 mm, and a length in the range from 10 to 2000 m, and a radius of curvature of 30 mm or more is preferably used as the substrate.

The present invention is described in detail below. The present invention, however, is not limited by the following description.

The organic EL device has a laminate obtained by laminating a first electrode layer, an organic EL layer, and a second electrode layer over a substrate in this order. Either of the first electrode layer and the second electrode layer is an anode, and the other is a cathode. The organic EL device production method according to the present invention is a method for producing an organic EL device by a roll-to-roll process, including: supplying a substrate from a delivery roll to a wind-up roll; forming a first electrode layer over the substrate; forming an organic EL layer over the first electrode layer; and forming a second electrode layer over the organic EL layer. The first electrode layer is formed using a shadow mask, at least a part of a side surface of the first electrode layer is a tapered surface of inwardly sloping from a lower side toward an upper side, and an angle formed between the tapered surface and a surface of the substrate on the side over which the first electrode layer is formed is 1° or less.

As the substrate, a metal plate or a metal foil of aluminium (Al), copper (Cu), stainless (SUS), or the like, a resin plate or a resin film of polyethylene (PE), polypropylene (PP), polystyrene (PS), polycarbonate (PC), polyimide (PI), a methacryl resin (PMMA), polyethylene terephthalate (PET), polyethylene naphthalate (PEN), or a cycloolefin resin (COP), a flexible glass, or the like can be used. The present invention is not limited by these substrates, and any of other materials applicable to the roll-to-roll process can be used. It is preferred that a recoverable long band-like substrate with a width in the range from 10 to 100 nm, a length in the range from 10 to 2000 m, and a radius of curvature of 30 mm or more is used as the substrate. The substrate is more preferably a recoverable long band-like substrate with a width in the range from 30 to 60 mm, a length in the range from 200 to 2000 m, and a radius of curvature of 10 mm or more.

In the case where a conductive substrate is used as the substrate, the surface of the conductive substrate over which an organic EL element is formed is required to have insulating properties. Therefore, in the case of using a conductive substrate, it is required to provide an insulating layer on the conductive substrate. As the insulating layer, for example, an inorganic insulating layer, an organic insulating layer, or a laminate of an inorganic insulating layer and an organic insulating layer can be used. The organic EL element may be formed over the insulating layer.

The inorganic insulating layer preferably contains at least one kind of a metal and a metalloid. At least one kind of a metal and a metalloid is preferably at least one kind selected from the group consisting of oxides, nitrides, carbides, oxynitrides, oxycarbides, carbonitrides, and oxycarbonitrides. Examples of the metal include zinc, aluminium, titanium, copper, and magnesium, and examples of the metalloid include silicon, bismuth, and germanium.

As the organic insulating layer, an insulating resin layer can be used. There is a case where the conductive substrate is heated at 150°C to 300°C in a production process. Therefore, a heat-resistant resin with a glass-transition temperature of 150°C or more is preferably selected. Specific examples of the heat-resistant resin include an acrylic resin, a norbornene resin, an epoxy resin, a polyimide resin, a polyamideimide resin, a polyamide resin, a polyester resin, a polyarylate resin, a polyurethane resin, a polycarbonate resin, a polyether ketone resin, a polyphenyl sulfone resin, and complexes of these resins. Among them, the heat-resistant resin is preferably at least one kind selected from the group consisting of an acrylic resin, a norbornene resin, en epoxy resin, and a polyimide resin.

As the first electrode layer, an indium-tin oxide (ITO), an indium-tin oxide containing silicone dioxide (ITSO), an indium-zinc oxide (IZO (registered trademark)), a metal such as gold, platinum, nickel, tungsten, copper, or aluminium, an alkali metal such as lithium or cesium, an alkali earth metal such as magnesium or calcium, a rare-earth metal such as ytterbium, or an alloy such as an aluminium-lithium alloy or a magnesium-silver alloy can be used.

In the organic EL device production method according to the present invention, the first electrode layer is formed using a shadow mask. The first electrode layer can be formed by, for example, a sputtering method, a vapor deposition method, or a CVD method. The shadow mask can be a shadow mask composed of stainless (SUS), aluminium (Al), copper (Cu), or the like and however is not limited thereby. The thickness of the shadow mask is preferably from 10 to 2000 µm, more preferably from 20 to 500 µm.

An angle formed between the tapered surface and a surface of the substrate on the side over which the first electrode layer is formed is 1° or less, preferably in the range from 0.03° to 1°, more preferably from 0.1° to 1°. As in the examples described below, there is a case where the end of the first electrode layer is not formed into not a film shape but a sea-island shape. In this case, the angle represents an angle calculated from the gradient of 20% to 80% of the thickness of the first electrode layer. When the angle is 1° or more, the thickness of the organic EL layer at the end of the first electrode layer becomes locally thin, and an electric field becomes large, resulting in a problem that the element is easily destroyed. In the case where a photolithography step is used in formation of the first electrode layer, problems of increasing the costs, reducing the reliability by a residue generated by the step, and reducing a yield in addition to the problem of being difficult to make the angle be 1° or less are caused. Thus, in the present invention, a shadow mask is used.

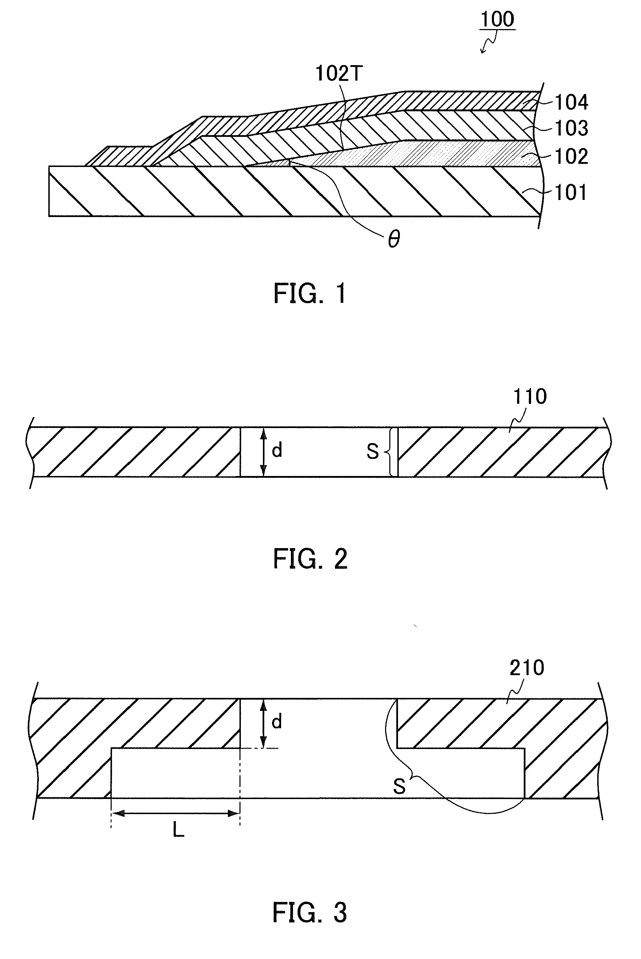

An angle formed between the tapered surface and a surface of the substrate on the side over which the first electrode layer is formed can be adjusted by the thickness of an inside end of an opening in the shadow mask. When the thickness is reduced, the angle can be increased, and when the thickness is increased, the angle can be reduced. Furthermore, the angle can be adjusted using the size of a gap between the substrate and the shadow mask at the time of forming the first electrode. When the gap is reduced, the angle can be increased, and when the gap is increased, the angle can be reduced. The thickness of an inside end of an opening in the shadow mask may be changed by changing the thickness of the shadow mask itself or by half-etching one surface of the inside end of an opening in the shadow mask on a film deposition source side. FIGs. 2 to 4 show examples of a cross-sectional shape of the inside surface of an opening in a shadow mask.

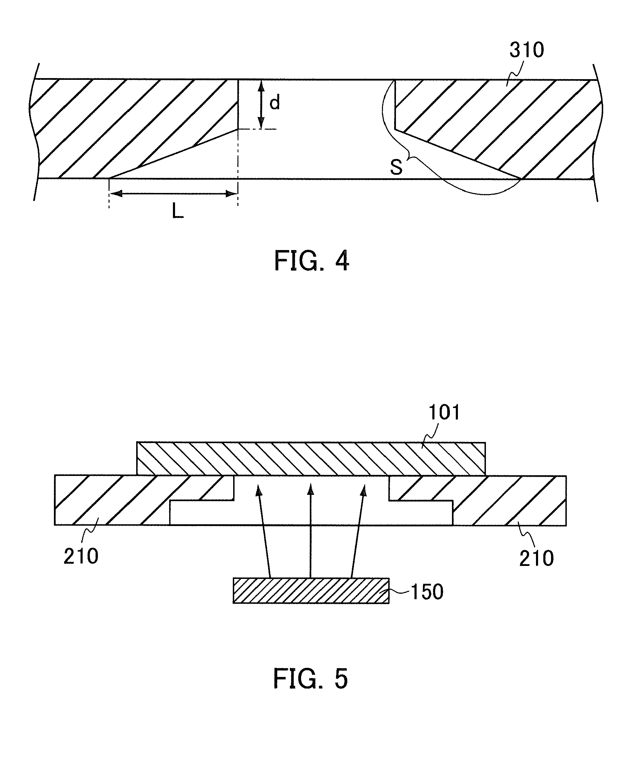

In the shadow mask of FIG. 2, the thickness of the inside end of the opening is equal to the thickness of the other part. Therefore, when the thickness of the inside end of the opening is intended to be thin, there is a case where the strength of the shadow mask itself becomes a problem. When the thickness of the inside end of the opening is intended to be thin, as in the shadow mask having a cross-sectional shape of FIG. 3 or 4, the cross-sectional shape of the inside surface S of the opening preferably has a multistage shape or a tapered shape. In this case, although the thickness of the vicinity of the opening is equal to the thickness of the shadow mask of FIG. 2, the thickness of the shadow mask other than the thickness of the vicinity of the opening can be thick. As described above, by using the shadow mask having a cross-sectional shape of FIG. 3 or 4, the strength of the shadow mask itself can be obtained, which is preferable. The thickness d of the inside end of an opening in the shadow mask is preferably in the range from 5 to 500 µm, more preferably from 50 to 300 µm. The thickness d in the above-described range is preferable to maintain the strength of the vicinity of the opening. The width L of a part in which the multistage shape or the tapered shape is formed is preferably in the range from d/5 to 5d, more preferably from d/3 to 3d. The width L in the above-described range is preferable because the strength of the vicinity of the opening can be maintained, and the pattern accuracy can be increased.

A method for providing a gap between the substrate and the shadow mask in the forming a first electrode layer can be a method in which the surface of the shadow mask at the vicinity of the opening on the substrate side is half-etched, a method in which a spacer intervenes between the shadow mask and the substrate, a method in which the shadow mask or the substrate is subjected to a knurling process, a method in which a pattern is formed in the substrate by a photolithography method, or the like.

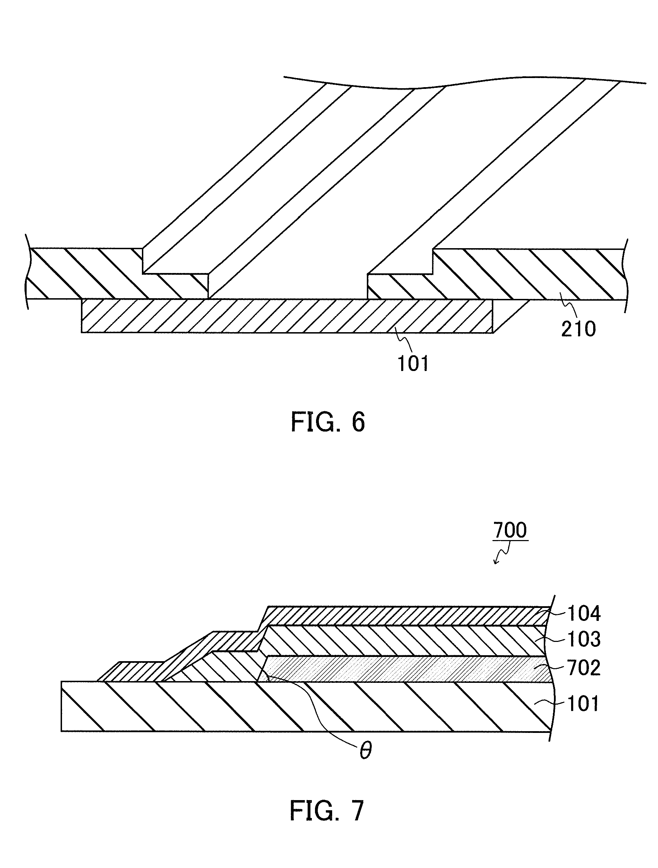

FIG. 5 is an explanatory drawing of arrangements of the substrate and the shadow mask in the forming a first electrode layer. FIG. 6 is a perspective view of the vicinity of an opening in the shadow mask in the forming a first electrode layer, viewed from the film deposition source. As shown in FIGs. 5 and 6, a film deposition source 150 is arranged so as to face a surface of a substrate 101 over which a first electrode layer is formed. The film deposition source 150 is a vapor deposition source, a sputtering target, or the like, containing a material for forming a first electrode layer. The shadow mask 210 is arranged between the substrate 101 and the film deposition source 150. The material for forming a first electrode layer is released from the film deposition source 150, and a first electrode layer is formed over the substrate 101 so as to correspond to a shape of the opening in the shadow mask 210. In FIGs. 5 and 6, the substrate 101 and the shadow mask 210 are arranged so as to adhere to each other. The present invention, however, is not limited thereby, and a space (gap) can be provided between the substrate and the shadow mask.

The organic EL layer at least includes a positive hole transport layer, a luminant layer, and an electron transport layer and may further include a positive hole injection layer and an electron injection layer as required. In the case where the first electrode layer is an anode, and the second electrode layer is a cathode, a positive hole injection layer, a positive hole transport layer, a luminant layer, an electron transport layer, and an electron injection layer are laminated in this order in the organic EL layer from the first electrode layer toward the second electrode layer, for example. On the other hand, in the case where the first electrode layer is a cathode, and the second electrode layer is an anode, a positive hole injection layer, a positive hole transport layer, a luminant layer, an electron transport layer, and an electron injection layer are laminated in this order in the organic EL layer from the second electrode layer toward the first electrode layer, for example.

A material for forming a positive hole transport layer is not particularly limited as long as it is a material that has a function of transporting a positive hole. Examples of the material for forming a positive hole transport layer include: aromatic amine compounds such as 4,4'-bis[N-(1-naphthyl)-N-phenylamino]biphenyl (NPB) and 4,4'-bis[N-(3-methylphenyl)-N-phenylaminolbiphenyl (TPD); a carbazole derivative such as 1,3-bis(N-carbazolyl)benzene; and polymers. The materials for forming a positive hole transport layer may be used alone or in a combination of two or more of them. Moreover, the positive hole transport layer may have a multilayer structure of two or more layers.

A material for forming a positive hole injection layer is not particularly limited, and examples thereof include HAT-CN (1,4,5,8,9,12-hexaazatriphenylene hexacarbonitrile), metal oxides such as vanadium oxide, niobium oxide, and tantalum oxide, a phthalocyanine compound such as phthalocyanine, a polymer such as a mixture of 3,4-ethylenedioxythiophene and polystyrene sulfonic acid (PEDOT/PSS), and materials for forming a positive hole transport layer. The materials for forming a positive hole injection layer may be used alone or in a combination of two or more of them.

A material for forming a luminant layer is not particularly limited as long as it is a material having luminescent properties. As the material for forming a luminant layer, a low-molecular-weight luminescent material such as a low-molecular-weight fluorescent material or a low-molecular-weight phosphorescent material can be used, for example. The material for forming a luminant layer may be a material having a luminescent function and an electron transport function or a positive hole transport function in combination.

Examples of the low-molecular-weight luminescent material include: an aromatic dimethylidene compound such as 4,4'-bis(2,2'-diphenylvinyl)-biphenyl (DPVBi); an oxadiazole compound such as 5-methyl-2-[2-[4-(5-methyl-2-benzoxazolyl)phenyl]vinyl]benzoxazole, a triazole derivative such as 3-(4-biphenylyl)-4-phenyl-5-t-butylphenyl-1,2,4-triazole, a styrylbenzene compound such as 1,4-bis(2-methylstyryl)benzene, an organic metal complex such as an azomethine-zinc complex or tris(8-quinolinato)aluminium (Alq₃), a benzoquinone derivative, a naphthoquinone derivative, an anthraquinone derivative, and a fluorenone derivative.

As the material for forming a luminant layer, a material obtained by doping a host material with a luminescent dopant material may be used.

As the host material, for example, any of the above-mentioned low-molecular-weight luminescent materials can be used, and besides any of these materials, any of carbazole derivatives such as 1,3-bis(N-carbazolyl)benzene (mCP), 2,6-bis(N-carbazolyl)pyridine, 9,9-di(4-dicarbazole-benzyl)fluorine (CPF), and 4,4'-bis(carbazole-9-yl)-9,9-dimethyl-fluorene (DMFL-CBP) can be used.

As the dopant material, for example, a phosphorescent metal complex such as an organic iridium complex such as tris(2-phenylpyridyl)iridium (III) (Ir(ppy)₃) or tris(1-phenylisoquinoline)iridium (III) (Ir(piq)₃), a styryl derivative, or a perylene derivative can be used.

Moreover, the material for forming a luminant layer may contain the above-mentioned material for forming a positive hole transport layer, a material for forming an electron transport layer described below, and various additives.

The material for forming an electron transport layer is not particularly limited as long as it is a material having an electron transport function. Examples of the material for forming an electron transport layer include: a metal complex such as bis(2-methyl-8-quinolinato)(4-phenylphenolato)aluminium (BAlq); a heteroaromatic compound such as 2-(4-biphenylyl)-5-(4-tert-butylphenyl)-1,3,4-oxadiazole (PBD) or 1,3-bis[5-(p-tert-butylphenyl)-1,3,4-oxadiazole-2-yl]benzene (OXD-7), and a polymer such as poly(2,5-pyridine-diyl) (PPy). The materials for forming an electron transport layer may be used alone or in a combination of two or more of them. Furthermore, the electron transport layer may have a multilayer structure of two or more layers.

The material for forming an electron injection layer is not particularly limited, and examples thereof include alkali metal compounds such as lithium fluoride (LiF) and cesium fluoride (CsF), an alkali earth metal compound such as calcium fluoride (CaF₂), and the materials for forming an electron transport layer. The materials for forming an electron injection layer may be used alone or in a combination of two or more of them. Moreover, the electron injection layer may have a multilayer structure of two or more layers.

A material for forming each layer that configures the organic EL layer is not particularly limited, and examples thereof include a sputtering method, a vapor deposition method, an ink-jet method, and a coating method. Although examples of a method for patterning the organic EL layer include a shadow mask method and a photolithography method, it is preferred that a pattern is formed using a shadow mask for forming an organic EL layer in the forming an organic EL layer from the viewpoint of damage to the organic EL layer, a resist residue, and the number of steps.

As the second electrode layer, an indium-tin oxide (ITO), an indium-tin oxide containing silicon oxide (ITSO), a metal such as gold, platinum, nickel, tungsten, copper, or aluminium, an alkali metal such as lithium or cesium, an alkali earth metal such as magnesium or calcium, a rare-earth metal such as ytterbium, an alloy such as an aluminium-lithium alloy or a magnesium-silver alloy, or the like can be used.

The second electrode layer can be formed by a sputtering method, a vapor deposition method, a CVD method, or the like, for example. Although examples of the method for patterning a second electrode layer include a shadow mask method and a photolithography method, a pattern is preferably formed using a shadow mask for forming a second electrode layer in the forming a second electrode layer from the viewpoint of damage to the organic EL layer, a resist residue, and the number of steps.

FIG. 1 is a schematic cross-sectional view showing an example of a configuration of an organic EL device according to the present invention. As shown in FIG. 1, a first electrode layer 102, an organic EL layer 103, and a second electrode layer 104 are laminated over a substrate 101 in this order in this organic EL device 100. At least a part of a side surface of the first electrode layer 102 is a tapered surface 102T of inwardly sloping from a lower side toward an upper side. The angle θ formed between the tapered surface 102T and a surface of the substrate 101 on the side over which the first electrode layer 102 is formed is 1° or less. The organic EL device according to the present invention can be produced by the organic EL device production method according to the present invention and, however, is not limited thereby.

### Examples

The examples of the present invention are described below together with the comparative examples. The present invention is not at all limited by the following examples and comparative examples. Various characteristics and physical properties in the examples and the comparative examples are measured and evaluated by the following methods.

### (Angle formed between tapered surface and surface of substrate on the side over which first electrode layer is formed)

There is a case where the end of the first electrode layer is formed into not a film shape but a sea-island shape. Therefore, an angle formed between the tapered surface and a surface of the substrate on the side over which the first electrode layer is formed was calculated from the gradient in 20% to 80% of the thickness of the first electrode layer. The gradient was measured by observing a cross section of the organic EL device with a scanning electron microscope manufactured by JEOL Ltd. (trade name: JSM-6610).

### (Leakage (element destruction rate))

100 organic EL devices each having a single luminescent part (element) with 20 mm × 100 mm were produced. Then, an application of a voltage from -8V to 8V by 0.1V/sec between a first electrode layer and a second electrode layer in each organic EL device was repeated a total of 100 times. By this operation, the number of organic EL devices with generated leakages was counted, and the element destruction rate was evaluated according to the following evaluation criteria:
A: Element destruction rate of 0% to 10%
B: Element destruction rate of more than 10% to 30% or less
C: Element destruction rate of more than 30% to 100% or less.

### (Yield (the number of dark spots))

5V was applied between the first electrode layer and the second electrode layer in the organic EL device after the leakage test, and a luminescent surface was observed by an optical microscope (digital microscope (trade name: VHX-1000) manufactured by KEYENCE CORPORATION). Then, the number of dark spots with a diameter of 10 µm or more was counted, and the yield was evaluated according to the following evaluation criteria:
G: The number of dark spots of 0 to 1 per 1 cm²
NG: The number of dark spots of 2 or more per 1 cm².

### [Example 1]

As a substrate for producing an organic EL element, provided was a substrate obtained by applying an insulating acrylic resin for organic EL (trade name: "JEM-477", manufactured by JSR Corporation) as a planarization layer on a SUS foil with a total length of 1000 m, a width of 30 mm, and a thickness of 50 µm and then drying and curing the SUS foil thus obtained. The substrate was subjected to a washing step and a heating step. Thereafter, a shadow mask for forming a first electrode layer that is composed of SUS and has a cross section of the inside surface of an opening in a multistage shape and a thickness d of the inside end of the opening of 100 µm was adhered on the substrate in an atmosphere of the degree of vacuum of 10⁻⁴ Pa or less. In this state, Al as a first electrode layer was vapor-deposited on the shadow mask by a vacuum vapor deposition method at a rate of 1 Å/sec (0.1 nm/sec) so as to have a thickness of 100 nm. As that time, the angle formed between the tapered surface and a surface of the substrate on the side over which the first electrode layer is formed was 0.03°. Thereafter, a shadow mask for forming an organic EL layer was adhered to a base material, and then, HAT-CN (thickness: 10 nm)/NPB (thickness: 50 nm)/Alq₃ (thickness: 50 nm)/LiF (thickness: 0.5 nm) as an organic EL layer was vapor-deposited on the shadow mask at a rate of 1 Å/sec (0.1 nm/sec). Subsequently, a shadow mask for forming a second electrode layer was adhered to a base material, and Al (thickness: 1 nm)/Ag (thickness: 19 nm) as a second electrode layer was vapor-deposited on the shadow mask. As described above, organic EL elements were formed over the substrate and wound up. Thereafter, the organic EL elements were wound off in an atmosphere of inert gas and cut by each element. The element was sealed with a sealing plate made of glass, being a plate with a thickness of 1.1 mm provided with a cyclic concave part with a height of 0.4 mm and a width of 2 mm from the circumferential edge of the plate so that the element can be in the state where the terminal connection from the first electrode layer (anode) and the second electrode layer (cathode) can be performed in the state of covering the luminescent part. Thus, an organic EL device of the present example was obtained. For the adhesion of the sealing plate, a two-part normal-temperature curable epoxy adhesive (trade name: "Quick 5" manufactured by Konishi Co., Ltd.) was applied to the circumferential edge of the sealing plate, and a drying agent (trade name: MOISTURE GETTER SHEET, manufactured by Dynic Corporation) was applied in a convex part of the sealing plate.

### [Example 2]

An organic EL device of the present example was obtained in the same manner as in Example 1 except that the thickness d of the inside end of the opening in the shadow mask for forming a first electrode layer was 50 µm, and an angle formed between the tapered surface and a surface of the substrate on the side over which the first electrode layer was formed was 0.06°.

### [Example 3]

An organic EL device of the present example was obtained in the same manner as in Example 1 except that the thickness d of the inside end of the opening in the shadow mask for forming a first electrode layer was 25 µm, and the angle formed between the tapered surface and a surface of the substrate on the side over which the first electrode layer was formed was 0.11°.

### [Example 4]

An organic EL device of the present example was obtained in the same manner as in Example 1 except that the thickness d of the inside end of the opening in the shadow mask for forming a first electrode layer was 10 µm, and the angle formed between the tapered surface and a surface of the substrate on the side over which the first electrode layer was formed was 0.29°.

### [Example 5]

An organic EL device of the present example was obtained in the same manner as in Example 1 except that the thickness d of the inside end of the opening in the shadow mask for forming a first electrode layer was 5 µm, and the angle formed between the tapered surface and a surface of the substrate on the side over which the first electrode layer was formed was 0.57°.

### [Example 6]

An organic EL device of the present example was obtained in the same manner as in Example 1 except that IZO as a first electrode layer was vapor-deposited by a vacuum vapor deposition method at a rate of 1Å /sec (0.1nm/sec) so as to have a thickness of 100 nm, and the angle formed between the tapered surface and a surface of the substrate on the side over which the first electrode layer was formed was 0.05°.

### [Example 7]

An organic EL device of the present example was obtained in the same manner as in Example 6 except that ITO as a first electrode layer was vapor-deposited by a vacuum vapor deposition method at a rate of 1Å /sec (0.1nm/sec) so as to have a thickness of 100 nm. The angle formed between the tapered surface and a surface of the substrate on the side over which the first electrode layer was formed was 0.05°.

### [Comparative Example 1]

An organic EL device of the present comparative example was obtained in the same manner as in Example 1 except that a pattern was formed in a substrate by a photolithography method using a resist for liftoff (trade name: "FNPR-L3", manufactured by FUJI CHEMICAL INDUSTRIAL CO., LTD.), an AL layer with a thickness of 100 nm was formed by a sputtering method, and the pattern was lifted off to form a first electrode layer. The angle formed between the tapered surface and a surface of the substrate on the side over which the first electrode layer was formed was 3°.

### [Comparative Example 2]

An organic EL device of the present comparative example was obtained in the same manner as in Example 1 except that an Al layer with a thickness of 100 nm was formed over a substrate by a sputtering method, and Al was etched by a photolithography method to form a first electrode layer. The angle formed between the tapered surface and a surface of the substrate on the side over which the first electrode layer was formed was 30°.

### [Comparative Example 3]

An organic EL device of the present comparative example was obtained in the same manner as in Example 1 except that an IZO layer with a thickness of 100 nm was formed over a substrate by a sputtering method, and IZO was etched by a photolithography method to form a first electrode layer. The angle formed between the tapered surface and a surface of the substrate on the side over which the first electrode layer was formed was 40°.

### [Comparative Example 4]

An organic EL device of the present comparative example was obtained in the same manner as in Example 1 except that an ITO layer with a thickness of 100 nm was formed over a substrate by a sputtering method, and ITO was etched by a photolithography method to form a first electrode layer. The angle formed between the tapered surface and a surface of the substrate on the side over which the first electrode layer was formed was 80°.

### [Evaluation]

A leakage (element destruction rate) and a yield rate (the number of dark spots) of each of the organic EL devices obtained in the examples and the comparative examples were measured and evaluated. The results are shown in Table 1.

**[Table 1]**

| | Angle | Material for forming first electrode layer | Patterning method | Leak (element destruction rate) | Yield (the number of dark spots) |
|---|---|---|---|---|---|
| Ex. 1 | 0.03° | Al | Shadow mask | A | G |
| Ex. 2 | 0.06° | Al | Shadow mask | A | G |
| Ex. 3 | 0.11° | Al | Shadow mask | A | G |
| Ex. 4 | 0.29° | Al | Shadow mask | A | G |
| Ex. 5 | 0.57° | Al | Shadow mask | A | G |
| Ex. 6 | 0.05° | IZO | Shadow mask | A | G |
| Ex. 7 | 0.05° | ITO | Shadow mask | A | G |
| Comp. Ex. 1 | 3° | Al | Liftoff | B | NG |
| Comp. Ex. 2 | 30° | Al | Photo etching | B | NG |
| Comp. Ex. 3 | 40° | IZO | Photo etching | B | NG |
| Comp. Ex. 4 | 80° | ITO | Photo etching | C | NG |

As shown in Table 1, in each of the organic EL devices obtained in the examples, the leakage (element destruction rate) and the number of generated dark spots were low. Thus, it turned out that, by reducing the stress concentration to the end of each layer, the peeling caused by the stress concentration was suppressed. In contrast, in Comparative Examples 1 to 4 with the angle of more than 1°, destruction of element occurred. FIG. 7 shows a schematic cross-sectional view of a configuration of the organic EL device 700 of the comparative examples. In FIG. 7, identical parts to those in FIG. 1 are denoted by identical reference numerals. As shown in FIG. 7, it is considered that an organic EL layer 103 at the end of a first electrode layer 702 in the organic EL device 700 of the comparative examples is thin because the angle θ is large. It is considered that the destruction of element is caused by the thin organic EL layer in addition to the peeling caused by the stress concentration to the end of each layer. Moreover, the number of generated dark spots was large compared with the organic EL devices obtained in the examples. This is considered that the liftoff step and the photo-etching step include a step of removing an unnecessary part of a formed photoresist layer and a formed first electrode layer, and thus, residues of a photoresist and a material for forming an electrode remain on the substrate, and the generation of dark spots is caused by the residues. Comparing the examples and the comparative examples, it turned out that, according to the present invention, the leakage (element destruction rate) and the yield (the number of dark spots) were suppressed, and an organic EL device with high reliability was obtained.

### Industrial Applicability

By the organic EL device production method according to the present invention, it becomes possible to continuously produce an organic EL device with superior reliability. The organic EL device according to the present invention can be used in various fields such as a light device and a display element, and the use thereof is not limited.

### Explanation of reference numerals

- 100, 700: organic EL (electroluminescence) device
- 101: substrate
- 102, 702: first electrode layer
- 102T: tapered surface
- 103: organic EL (electroluminescence) layer
- 104: second electrode layer
- 110, 210, 310, 410: shadow mask
- 150: film deposition source

## Claims

1. A method for producing an organic EL device, comprising:
supplying a substrate from a delivery roll to a wind-up roll;
forming a first electrode layer over the substrate;
forming an organic EL layer over the first electrode layer; and
forming a second electrode layer over the organic EL layer, wherein
the first electrode layer is formed using a shadow mask,
at least a part of a side surface of the first electrode layer is a tapered surface of inwardly sloping from a lower side toward an upper side, and
an angle formed between the tapered surface and a surface of the substrate on the side over which the first electrode layer is formed is 1° or less.

2. The method according to claim 1, wherein
a cross-sectional shape of an inside surface of an opening in the shadow mask has a tapered shape or a multistage shape.

3. The method according to claim 1 or 2, wherein
an inside end of an opening in the shadow mask has a constant thickness, and
the thickness is in the range from 5 to 500 µm.

4. The method according to any one of claims 1 to 3, wherein
in the forming an organic EL layer, the organic EL layer is formed using a shadow mask for forming an organic EL layer.

5. The method according to any one of claims 1 to 4, wherein
in the forming a second electrode layer, the second electrode layer is formed using a shadow mask for forming a second electrode layer.

6. The method according to any one of claims 1 to 5, wherein
a recoverable long band-like substrate with a width in the range from 10 to 100 mm, a length in the range from 10 to 2000 m, and a radius of curvature of 30 mm or more is used as the substrate.

7. An organic EL device comprising:
a flexible substrate;
a first electrode layer;
an organic EL layer; and
a second electrode layer, the first electrode layer, the organic EL layer, and the second electrode layer being laminated over the flexible substrate in this order, wherein
at least a part of a side surface of the first electrode layer is a tapered surface of inwardly sloping from a lower side toward an upper side, and
an angle formed between the tapered surface and a surface of the substrate on the side over which the first electrode layer is formed is 1° or less.
